Europäisches Patentamt

European Patent Office

Office européen des brevets

(19)

(11) Veröffentlichungsnummer: **0 121 605**
**A2**

(12) # EUROPÄISCHE PATENTANMELDUNG

(21) Anmeldenummer: 83112966.3

(22) Anmeldetag: 22.12.83

(51) Int. Cl.³: **H 01 L 21/60**, H 01 L 23/48

(30) Priorität: 20.01.83 DE 3301666

(43) Veröffentlichungstag der Anmeldung: 17.10.84
Patentblatt 84/42

(84) Benannte Vertragsstaaten: **CH DE FR GB IT LI NL**

(71) Anmelder: **BROWN, BOVERI & CIE Aktiengesellschaft,
Kallstadter Strasse 1, D-6800 Mannheim 31 (DE)**

(72) Erfinder: **Neidig, Arno, Dr. Dipl.-Phys., Brühlerweg 42,
D-6831 Plankstadt (DE)**
Erfinder: **Irons, Robert Charles, Dipl.-Chem., Berliner
Strasse 50, D-6700 Ludwigshafen (DE)**

(74) Vertreter: **Kempe, Wolfgang, Dr. et al, c/o Brown, Boveri
& Cie AG Postfach 351, D-6800 Mannheim 1 (DE)**

(54) Verfahren zur Herstellung einer mehrschichtigen Kontaktmetallisierung auf einem Silizium-Halbleiterbauelement.

(57) Dieses Verfahren dient zur Aufbringung einer mehrschichtigen, gut haftenden und weichlotfähigen Kontaktmetallisierung (7) auf die hochdotierte Oberfläche eines Silizium-Halbleiterbauelementes (1) und findet vorzugsweise Anwendung bei Leistungshalbleiterbauelementen, wie Thyristoren. Als erste Schicht (2) wird ein Metall wie Nickel aufgebracht, das mit Silizium leicht ein Silizid bildet. Als zweite Schicht (3) dient ein Metall wie Chrom, dessen Silizidbildung wesentlich langsamer verläuft als bei Nickel. Als dritte Schicht (4) schließt sich ein Metall wie Nickel an, das nur wenig von Weichloten angelöst wird. Als vierte Schicht (5) wird eine Übergangsschicht aus Nickel und einem Edelmetall, vorzugsweise Silber, aufgebracht, die allmählich in eine fünfte Schicht (6), eine Schutzschicht aus Silber, übergeht. Alternativ hierzu können Nickel und Chrom der ersten und zweiten Schicht auch gemeinsam aufgebracht werden.

EP 0 121 605 A2

BROWN, BOVERI & CIE    AKTIENGESELLSCHAFT

Mannheim                          18. Jan. 1983

Mp.-Nr. 504/83                    ZPT/P3-Pn/Bt

BEZEICHNUNG GEÄNDERT
siehe Titelseite

Verfahren zur Herstellung einer mehrschichtigen
Kontaktmetallisierung

Die Erfindung bezieht sich auf ein Verfahren zur Herstellung einer mehrschichtigen Kontaktmetallisierung gemäß dem Oberbegriff des Anspruchs 1.

Ein derartiges Verfahren zur Herstellung einer mehrschichtigen Kontaktmetallisierung ist aus der DE-AS 20 09 863 bekannt. Dort dient als Haftschicht zu Silizium eine aufgedampfte Schicht aus Chrom und Vanadium. Als zweite Schicht wird Nickel aufgebracht und als dritte Schicht dient eine Silberschicht. Als vierte Schicht ist eine Gold- und/oder Chromschicht vorgesehen. Es hat sich jedoch herausgestellt, daß ein direktes Aufbringen der Chromschicht auf eine hochdotierte und mechanisch nicht aufgerauhte (Läppen, Sandstrahlen) Siliziumoberfläche nicht immer zu einer verläßlichen Haftung nach Temperaturbehandlungen führt. Dies hat seine Ursache darin, daß die Silizid-Bildung mit Chrom erst bei höheren Temperaturen erfolgt.

0121605

Bei einem weiteren Verfahren zur Herstellung einer mehrschichtigen Kontaktmetallisierung gemäß DE-OS 28 09 863
werden Aluminium als gut haftende, erste Schicht sowie
Chrom, Nickel und Gold als weitere Schichten verwendet.
Wenn nach Aufbringung der Aluminiumschicht nachfolgende
Temperaturbehandlungen an der Siliziumscheibe durchgeführt werden müssen, erweist sich Aluminium als Nachteil, da sich Silizium leicht in Aluminium löst; während
der Temperaturbehandlung wandern Silizium und Aluminium
durch die Chrom- und Nickelschichten und verhindern eine
Benetzung mit Weichloten.

Bei einem weiteren Verfahren zur Herstellung einer mehrschichtigen Kontaktmetallisierung gemäß DE-AS 16 14 658
wird ein Zweischichten-System aus Aluminium (oder Magnesium) und Silber (oder Kupfer, Palladium) verwendet,
wobei die Silberschicht sehr dick gewählt wird, um eine
vollständige Umwandlung und Auflösung der Schicht bei
anschließenden Temperatubehandlungen und während des
Weichlötens zu verhindern. Das Aufbringen der dicken
Silberschicht ist jedoch aufwendig und teuer. Dicke
Schichten sind außerdem von Nachteil, wenn Fotolack als
Maskierung verwendet wird, der im anschließenden Temperprozeß verdampft bzw. verascht wird, wobei die Metallschicht an den zu maskierenden Stellen aufgerissen und
abgelöst werden soll (sogenannter "lift-off-Prozeß").

Der Erfindung liegt davon ausgehend die Aufgabe zugrunde, ein Verfahren zur Herstellung einer mehrschichtigen,
gut haftenden und weichlotfähigen Kontaktmetallisierung
für hochdotierte, glatte Siliziumoberflächen der eingangs genannten Art anzugeben, wobei auch eine vorausgehende Maskierung mit Fotolack und ein anschließender
"lift-off-Prozeß" in einfacher Weise möglich sein
sollen.

Diese Aufgabe wird durch die im Anspruch 1 gekennzeichneten Merkmale gelöst.

Die mit der Erfindung erzilebaren Vorteile bestehen insbesondere darin, daß die Schichten der Kontaktmetallisierung aus nur drei verschiedenen Metallen aufgebaut
sind, was den Aufwand bei der Herstellung reduziert. Die
Kontaktmetallisierung ist so aufgebaut, daß sie sich
einfach und leicht in physikalischen Aufdampf-Anlagen
herstellen läßt. Das physikalische Aufdampf-Verfahren
wird zwar bevorzugt, jedoch ist ebenso ein Aufbringen
der Schichten durch Kathoden-Zerstäubung eine mögliche
Alternative.

Vorteilhafte Ausgestaltungen der Erfindung sind den
Unteransprüchen entnehmbar.

Die Erfindung wird nachstehend anhand der in den Zeichnungen dargestellten Ausführungsform erläutert.

Es zeigen:
Fig. 1          den Aufbau der mehrschichtigen Kontaktmetallisierung,
Fig. 2a bis 2e einzelne Verfahrensschritte bei der Herstellung eines Bauelementes.

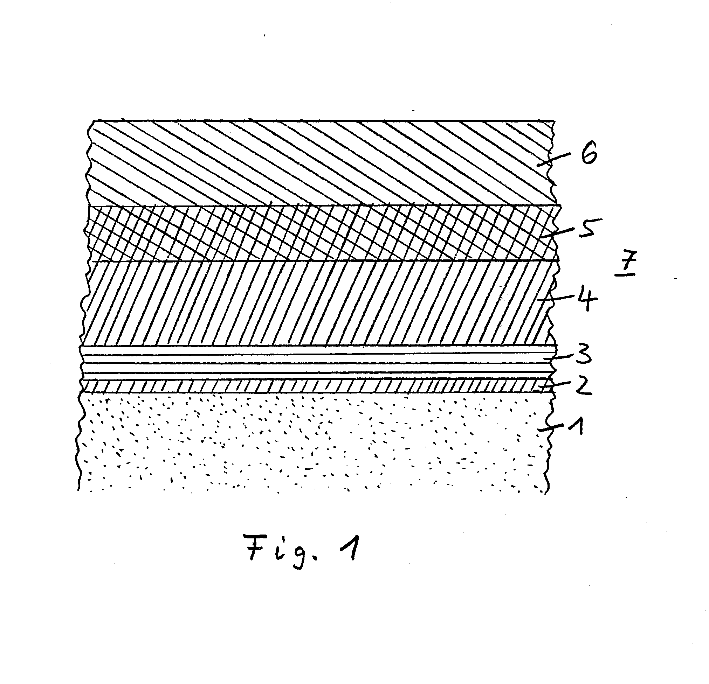

In Fig. 1 ist der Aufbau der mehrschichtigen Kontaktmetallisierung dargestellt. Die Kontaktmetallisierung ist
auf der niederohmigen, also hochdotierten Oberfläche
eines vorzugsweise scheibenförmigen Silizium-Halbleiterbauelementes 1 aufgebracht. Die hochdotierte Oberfläche
entsteht nach Auftragung von Dotierstoffquellen-Schichten und anschließender Diffusion. Die Oberfläche des
Silizium-Halbleiterbauelementes 1 ist nicht durch mechanische Methoden, wie Läppen oder Sandstrahlen bzw. stark
abtragende Ätzverfahren nachbehandelt. Eine leichte Ätzreinigung ist jedoch üblich, wobei der Silizium-Nachtrag $\leq 5$ µm beträgt.

Als erste Schicht der Kontaktmetallisierung wird eine 5 bis 50 nm dicke Nickelschicht 2 auf die Oberfläche des Silizium-Halbleiterbauelementes 1 aufgedampft. Die erste Schicht 2 hat die Aufgabe, bei nachfolgenden Temperaturbehandlungen die Silizid-Bildung mit der hochdotierten Siliziumoberfläche zu erleichtern. Auf diese Weise wird eine sehr gute Haftung der gesamten Kontaktmetallisierung durch die Reaktion zwischen den beiden Festkörpern Nickel und Silizium erreicht. Nickel bildet mit Silizium leicht ein Silizid. Die Silizid-Bildung ($Ni_2Si$, $NiSi$) erfolgt dabei ab etwa 250ºC, je nach Dauer und Temperatur entsteht eine der Verbindungen $Ni_2Si$ oder $NiSi$.

Anstelle von Nickel können auch andere Metalle eingesetzt werden, die leicht Silizide bilden, wie z.B. Platin und Palladium. Nickel wird jedoch aus Kostengründen bevorzugt.

Die Dicke der ersten Schicht 2 ist kein kritischer Parameter; sie ist nach unten begrenzt durch die Tatsache, daß sich dünnere Schichten als 5 nm nur schwer definiert herstellen lassen. Dickere Schichten als 50 nm aufzubringen ist nicht mehr sinnvoll, da die Funktion eines Reaktionsanreizes zur Silizid-Bildung auch von einer dünneren Schicht erfüllt wird. Bevorzugt wird eine Dicke von 10 nm.

Als zweite Schicht der Kontaktmetallisierung wird eine 50 bis 100 nm dicke Chromschicht 3 auf die Nickelschicht 2 aufgedampft. Diese zweite Schicht aus Chrom hat nun nur noch die Funktion einer Silizierungsbremse, da die Silizid-Bildung ($CrSi_2$) mit Chrom erst bei höheren Temperaturen als bei Nickel, d.h. erst ab ca. 400ºC erfolgt

und bei gleicher Temperatur langsamer verläuft als die Ni$_2$Si- oder NiSi-Bildung. Dadurch wird die genaue Einhaltung der Temperatur und der Zeitdauer bei der nachfolgenden Temperaturbehandlung unkritischer. Es sind zwar auch andere Metalle als langsame Silizidbildner bekannt, wie z.B. Mo, W, Ti; jedoch wird Chrom bevorzugt, weil es sich leicht verdampfen läßt und nicht in Nickel diffundiert. Chrom hat noch den weiteren Vorteil, daß es nicht mit Nickel bei Temperaturen unter 500°C reagiert.

Eine Alternative des Verfahrens besteht darin, daß die erste und zweite Schicht zusammengefaßt werden, indem eine NiCr-Schicht aufgedampft wird; dies kann aus zwei getrennten Aufdampfquellen geschehen oder aus einer einzigen Quelle durch Elektronenstrahl-Verdampfung. Dabei sollte der Chromanteil zwischen 50 Atom% und 80 Atom% liegen. Der Schichtdickenbereich ist bei dieser Variante 50 bis 150 nm und wird bestimmt durch die Funktion als Silizierungsbremse bei der nachfolgenden Temperaturbehandlung.

Als dritte Schicht der Kontaktmetallisierung wird eine 300 bis 700 nm dicke Nickelschicht 4 auf die Chromschicht 3 aufgedampft. Nickel wird bei dieser Schicht deshalb verwendet, weil es in idealer Weise gut mit üblichen Weichloten benetzbar ist und gleichzeitig nur langsam vom Weichlot angelöst wird. Von den wenigen möglichen, in Weichloten sich langsam auflösenden Metallen wird Nickel aus Kostengründen bevorzugt, desweiteren, weil es sich leicht durch Elektronenstrahlverdampfung aufbringen läßt. Die Dicke der Nickelschicht ist nach unten begrenzt wegen der Anlöserate in Weichloten und nach oben wegen der Sprödigkeit des Nickels.

Als vierte Schicht der Kontaktmetallisierung wird eine 100 bis 200 nm dicke Nickel/Silber-übergangsschicht 5 auf die Nickelschicht 4 aufgedampft. Bei dieser Schicht 5 nimmt der Nickelanteil zur Oberfläche hin ab und der Silberanteil nimmt im gleichen Maß zu bis schließlich nur noch Silber aufgebracht wird. Die einzelnen Anteile werden durch Zurücknehmen der Nickel-Aufbringungsrate und Erhöhen der Silber-Aufbringungsrate eingestellt. Diese vierte Schicht dient zur Verbesserung der Haftung zwischen der nachfolgenden fünften Schicht, der Silberschicht 6 und der Nickelschicht 4 und ist nicht unbedingt erforderlich.

Als fünfte und letzte Schicht der Kontaktmetallisierung wird eine 200 bis 2000 nm dicke Silberschicht 6 auf die Nickel/Silber-übergangsschicht 5 aufgedampft. Die Silberschicht 6 löst sich leicht in Lot und schützt Nickel vor Oxidation. Silber wird gegenüber Gold unter anderem aus Kostengründen bevorzugt. Die Dicke der Silberschicht 6 wird nach unten durch die Tatsache begrenzt, daß Nickel während einer Temperaturbehandlung bei mehr als 400°C über Korngrenzen durch die Silberschicht an die Oberfläche diffundiert, was an einer rosa bis braunen Färbung der Oberfläche sichtbar wird. Diese dünne Nickelschicht oxidiert leicht und behindert die Benetzung mit Weichloten. Die obere Grenze der Silberschicht-Dicke ist gegeben durch die Kosten und durch den bei der weiteren Herstellung des Bauelementes nötigen "lift-off-Prozeß". Der "lift-off-Prozeß" läßt sich bei zu dicken Silberschichten nicht mehr in einfacher Weise durchführen.

Die aus den Schichten 2, 3, 4, 5 und 6 bestehende Anordnung wird als Kontaktmetallisierung 7 bezeichnet. Das Aufbringen einzelner Schichten erfolgt vorzugsweise mittels physikalischer Aufdampfverfahren in einem Hochvakuum bei einem Druck von weniger als $1 \cdot 10^{-5}$ mbar. Alter-

0121605

nativ hierzu kann das Aufbringen der Schichten auch mittels eines Kathoden-Zerstäubungsverfahrens erfolgen.

In den Figuren 2a bis 2e sind als Beispiel die einzelnen Verfahrensschritte beim Herstellungsprozeß eines Bauelementes (Diode) dargestellt. Als Ausgangsmaterial dienen diffundierte, scheibenförmige Silizium-Halbleiterbauelemente 1, mit einer oberen p-dotierten Schicht 1a, einer mittleren Schicht 1b aus N--Grundmaterial und einer unteren N+-dotierten Schicht 1c, wie in Fig. 2a dargestellt.

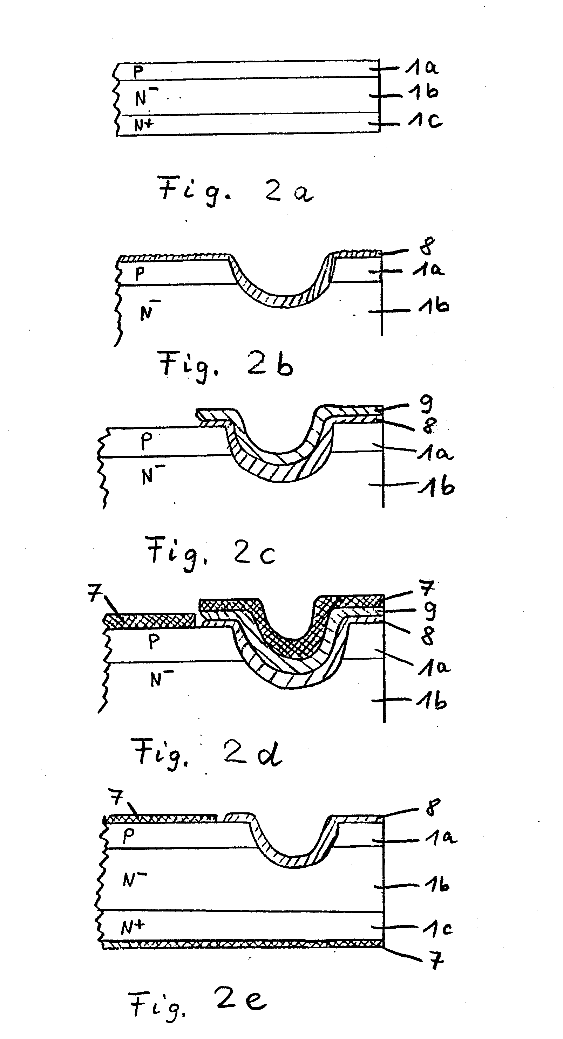

Nach Grabenätzung und Glaspassivierung ergibt sich die Anordnung gemäß Fig. 2b mit einer die Oberfläche des Halbleiterbauelementes überdeckenden Glasschicht 8. Nach darauffolgender Maskierung durch eine Fotolackschicht 9 und einer Glasätzung und Reinigung im Kontaktbereich ergibt sich die in Fig. 2c dargestellte Anordnung. Anschließend wird die mehrschichtige Kontaktmetallisierung 7, wie unter Fig. 1 beschrieben, aufgedampft, was zu einer Anordnung gemäß Fig. 2d führt. Danach schließt sich ein Temperprozeß an, wobei die maskierten Stellen der Siliziumscheibe verascht bzw. verdampft werden. Dadurch werden die über der Maskierungsschicht liegenden Kontaktmetallisierungen 7 aufgerissen und können abgelöst werden (lift-off-Prozeß).

Die Erfindung findet vorzugsweise Anwendung auf dem Gebiet der Leistungshalbleiterbauelemente (wie z.B. Thyristoren).

A n s p r ü c h e

1. Verfahren zur Herstellung einer mehrschichtigen Kontaktmetallisierung auf der hochdotierten Oberfläche eines Silizium-Halbleiterbauelementes, dadurch gekennzeichnet, daß als erste Schicht ein Metall aufgebracht wird, das mit Silizium leicht ein Silizid bildet, daß als zweite Schicht ein Metall aufgebracht wird, dessen Silizidbildung wesentlich langsamer verläuft als in der ersten Metallschicht, daß als dritte Schicht ein Metall aufgebracht wird, das nur wenig von Weichloten angelöst wird und daß als letzte Schicht eine Schutzschicht aus einem Edelmetall aufgebracht wird.

2. Verfahren nach Anspruch 1, dadurch gekennzeichnet, daß die dritte Schicht über eine nachfolgende Übergangsschicht, zusammengesetzt aus dem Metall der dritten Schicht und dem Edelmetall, allmählich in die Schutzschicht übergeht.

3. Verfahren nach Anspruch 1, dadurch gekennzeichnet, daß als erste Schicht eine 5 bis 50 nm dicke Nickelschicht aufgebracht wird.

4. Verfahren nach Anspruch 1, dadurch gekennzeichnet, daß als zweite Schicht eine 50 bis 100 nm dicke Chromschicht aufgebracht wird.

5. Verfahren nach Anspruch 1, dadurch gekennzeichnet, daß als dritte Schicht eine 300 bis 700 nm dicke Nickelschicht aufgebracht wird.

6. Verfahren nach Anspruch 1, dadurch gekennzeich-

504/83 9 0121605

net, daß als Schutzschicht eine 200 bis 2000 nm dicke Silberschicht aufgebracht wird.

7. Verfahren nach Anspruch 2, dadurch gekennzeichnet, daß als Übergangsschicht eine 100 bis 200 nm dicke Nickel/Silber-Schicht aufgebracht wird.

8. Verfahren nach einem der vorstehenden Ansprüche, dadurch gekennzeichnet, daß die für die erste und die zweite Schicht vorgesehenen Metalle Nickel und Chrom gemeinsam zur Bildung einer einzigen Schicht aufgebracht werden.

9. Verfahren nach Anspruch 8, dadurch gekennzeichnet, daß der Chromanteil der gemeinsamen Schicht im Bereich 50 bis 80 Atom% liegt.

10. Verfahren nach Anspruch 8, dadurch gekennzeichnet, daß die Dicke der gemeinsamen Schicht im Bereich 50 bis 150 nm liegt.

11. Verfahren nach einem der vorstehenden Ansprüche, dadurch gekennzeichnet, daß das Aufbringen der Schichten mittels eines physikalischen Aufdampfverfahrens in einem Hochvakuum bei einem Druck von weniger als $1 \cdot 10^{-5}$ mbar erfolgt.

12. Verfahren nach einem der vorstehenden Ansprüche, dadurch gekennzeichnet, daß das Aufbringen der Schichten mittels eines Kathoden-Zerstäubungsverfahrens erfolgt.

Fig. 1

Fig. 2a

Fig. 2b

Fig. 2c

Fig. 2d

Fig. 2e